# EUROPEAN PATENT APPLICATION

(11) **EP 3 648 347 A1**
(43) Date of publication of application: **06.05.2020**
(21) Application number: 17919228.1
(22) Date of filing: 27.07.2017
(51) Int. Cl.: H03H 7/42

(54) **IN-PHASE SUPPRESSION CIRCUIT**

(71) Applicant: Mitsubishi Electric Corporation, Chiyoda-ku Tokyo 100-8310 (JP)
(72) Inventor: INAGAKI, Ryuji, Tokyo 100-8310 (JP); SOMADA, Ichiro, Tokyo 100-8310 (JP); TSURU, Masaomi, Tokyo 100-8310 (JP); SHIMOZAWA, Mitsuhiro, Tokyo 100-8310 (JP)
(74) Representative: Pfenning, Meinig & Partner mbB
(86) International application number: PCT/JP2017/027280
(87) International publication number: WO 2019/021427

(57) **Abstract**

A circuit includes: a first line (11) in which one end thereof (11a) is coupled to a first signal input terminal (1a); a second line (12) in which one end thereof (12a) is grounded and the other end thereof (12b) is coupled to a first signal output terminal (4a), the second line (12) being electromagnetically coupled to the first line (11); a third line (13) in which one end thereof (13a) is open, the third line (13) being electromagnetically coupled to the second line (12); a fourth line (21) in which one end thereof (21a) is coupled to the other end (11b) of the first line (11) and the other end thereof (21b) is open; a fifth line (22) in which one end thereof (22a) is coupled to a second signal output terminal (4b) and the other end thereof (22b) is grounded, the fifth line (22) being electromagnetically coupled to the fourth line (21); and a sixth line (23) in which one end thereof (23a) is coupled to the other end (13b) of the third line (13) and the other end thereof (23b) is coupled to a second signal input terminal (1b), the sixth line (23) being electromagnetically coupled to the fifth line (22).

## Description

### TECHNICAL FIELD

The present invention relates to an in-phase suppression circuit including a plurality of lines having a length of a quarter wavelength at a frequency of an input signal.

### BACKGROUND ART

For example, there are cases each in which a differential signal is used for signal transmission in an in-phase suppression circuitused in microwave band circuits or millimeter wave band circuits.

The transmission scheme using a differential signal is to transmit signals the same in amplitude as each other but phases thereof are different from each other and shifted by 180 degrees on two signal lines, and is capable of superimposing information on a difference in the potential between the signals on the two signal lines.

Therefore, a device on the receiving side of the differential signal acquires the information by detecting the difference in the potential between the signals on the two signal lines.

Here, since the difference in the potential between the signals on the two signal lines does not change even if in-phase noise is applied to the two signal lines, the transmission quality is not affected.

However, the two signals constituting the differential signal ideally have the same amplitude but reversed phases. However, in a case where an in-phase component is superimposed, which is called a common mode, an amplitude difference and a phase difference may be generated.

Each of the amplitude difference and the phase difference between the two signals constituting the differential signal causes the balance of the differential signal to be lost, thereby contributing to unnecessary oscillation, a spurious, or non-linearity.

Therefore, it is necessary to remove the superimposed in-phase component, and a differential amplifier having a high rejection ratio of the common mode is used as one of the methods of removing the in-phase component.

However, in a case where a differential amplifier having a high rejection ratio of the common mode, there are cases where in microwave bands or millimeter wave bands, a balun is employed which performs conversion between a balanced signal an unbalanced signal since it is necessary to suppress signal distortion caused by the differential amplifier or noise generated from the differential amplifier.

Non-Patent Literature 1 below discloses an in-phase suppression circuit including a first Marchand balun and a second Marchand balun as baluns for converting between a balanced signal and an unbalanced signal.

As described below, the first Marchand balun includes first to fourth transmission lines having a length of a quarter wavelength at a frequency of an input signal.
(1) First transmission line having one end coupled to a first signal input terminal.
(2) Second transmission line having one end grounded and the other end coupled to a second signal output terminal, the second transmission line being electromagnetically coupled to the first transmission line.
(3) Third transmission line having one end coupled to the other end of the first transmission line and the other end open.
(4) Fourth transmission line having one end coupled to a first signal output terminal and the other end grounded, the fourth transmission line electromagnetically coupled to the third transmission line.

As described below, the second Marchand balun includes fifth to eighth transmission lines having a length of a quarter wavelength at a frequency of an input signal.
(1) Fifth transmission line having one end coupled to a second signal input terminal.
(2) Sixth transmission line having one end grounded and the other end coupled to the first signal output terminal, the sixth transmission line electromagnetically coupled to the fifth transmission line.
(3) Seventh transmission line having one end coupled to the other end of the fifth transmission line and the other end open.
(4) Eighth transmission line having one end coupled to the second signal output terminal and the other end grounded, the eighth transmission line electromagnetically coupled to the seventh transmission line.

In this in-phase suppression circuit, when a differential signal is input from the first signal input terminal and the second signal input terminal, a differential signal is output from the first signal output terminal and the second signal output terminal.

In-phase signals input from the first signal input terminal and the second signal input terminal are canceled out, and thus are not output from the first signal output terminal and the second signal output terminal.

### CITATION LIST

### NON-PATENT LITERATURE

Non-Patent Literature 1:
K.S. Ang and I. D. Rebertson, "Analysis and Design of Impedance-Transforming Planar Marchand Baluns," IEEE Trans. On Microwave Theory and Techniques, vol. 49, no. 2, pp. 402-406, Feb. 2001.

### SUMMARY OF INVENTION

### TECHNICAL PROBLEM

Since the conventional in-phase suppression circuit is configured as described above, it is possible to suppress output of in-phase signals from the first signal output terminal and the second signal output terminal.

However, there is a disadvantage that it is necessary to mount eight transmission lines having a length of a quarter wavelength at a frequency of an input signal.

The present invention has been made to solve the above disadvantage, and it is an object of the present invention to obtain an in-phase suppression circuit capable of reducing the number of transmission lines compared to the case of using two Marchand baluns that are independent of each other.

### SOLUTION TO PROBLEM

An in-phase suppression circuit according to the present invention includes: a first line in which one end thereof is coupled to a first signal input terminal; a second line in which one end thereof is grounded and the other end thereof is coupled to a first signal output terminal, the second line being electromagnetically coupled to the first line; a third line in which one end thereof is open, the third line being electromagnetically coupled to the second line; a fourth line in which one end thereof is coupled to the other end of the first line and the other end is open; a fifth line in which one end thereof is coupled to a second signal output terminal and the other end thereof is grounded, the fifth line being electromagnetically coupled to the fourth line; and a sixth line in which one end thereof is coupled to the other end of the third line and the other end thereof is coupled to a second signal input terminal, the sixth line being electromagnetically coupled to the fifth line, wherein the first to sixth lines have a length of a quarter wavelength at a frequency of signals input from the first and second signal input terminals.

### ADVANTAGEOUS EFFECTS OF INVENTION

According to this invention, since the in-phase suppression circuit includes: a first line in which one end thereof is coupled to a first signal input terminal; a second line in which one end thereof is grounded and the other end thereof is coupled to a first signal output terminal, the second line being electromagnetically coupled to the first line; a third line in which one end thereof is open, the third line being electromagnetically coupled to the second line; a fourth line in which one end thereof is coupled to the other end of the first line and the other end is open; a fifth line in which one end thereof is coupled to a second signal output terminal and the other end thereof is grounded, the fifth line being electromagnetically coupled to the fourth line; and a sixth line in which one end thereof is coupled to the other end of the third line and the other end is coupled to a second signal input terminal, the sixth line being electromagnetically coupled to the fifth line. Therefore, there is an effect of reducing the number of transmission lines as compared with the case of using two Marchand balun independent of each other.

### BRIEF DESCRIPTION OF DRAWINGS

FIG. 1 is a configuration diagram illustrating an in-phase suppression circuit according to a first embodiment of the present invention.
FIG. 2 is an explanatory graph illustrating the amplitude of an S parameter S21 and the amplitude of an S parameter S31 when a differential signal is input.
FIG. 3 is an explanatory graph illustrating a phase difference between the S parameter S21 and the S parameter S31 when a differential signal is input.
FIG. 4 is an explanatory graph illustrating the amplitude of an S parameter S54 and the amplitude of an S parameter S64 when in-phase signals are input.
FIG. 5 is a configuration diagram illustrating a conventional in-phase suppression circuit including a first Marchand balun including first to sixth transmission lines and a second Marchand balun including seventh to twelfth transmission lines.
FIG. 6 is a configuration diagram illustrating an in-phase suppression circuit according to a second embodiment of the present invention.
FIG. 7 is a configuration diagram illustrating a conventional in-phase suppression circuit including a first Marchand balun including first to eighth transmission lines and a second Marchand balun including ninth to sixteenth transmission lines.
FIG. 8 is a configuration diagram illustrating an in-phase suppression circuit according to a third embodiment of the present invention.
FIG. 9 is a configuration diagram illustrating an in-phase suppression circuit according to a fourth embodiment of the present invention.
FIG. 10 is a configuration diagram illustrating an in-phase suppression circuit according to a fifth embodiment of the present invention.
FIG. 11 is a configuration diagram illustrating an in-phase suppression circuit according to a sixth embodiment of the present invention.

### DESCRIPTION OF EMBODIMENTS

To describe the present invention further in detail, embodiments for carrying out the present invention will be described below with reference to the accompanying drawings.

### First Embodiment

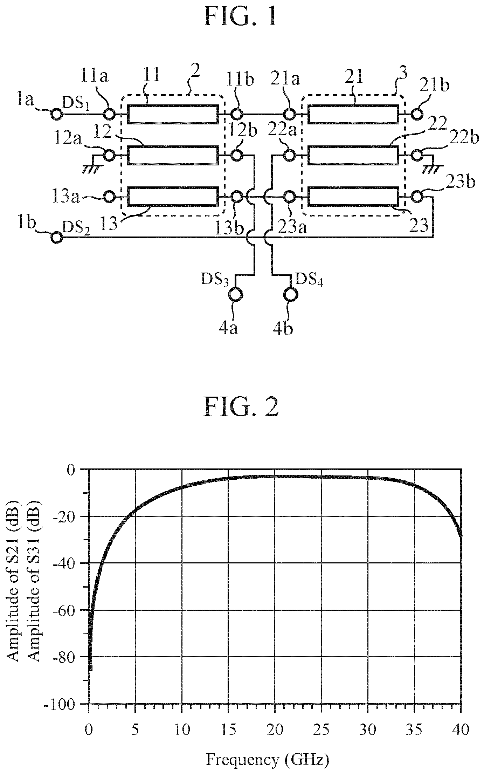

FIG. 1 is a configuration diagram illustrating an in-phase suppression circuit according to a first embodiment of the present invention.

In FIG. 1, a first signal input terminal 1a is a terminal for inputting a signal DS₁ in a microwave band or a millimeter wave band, for example.

A second signal input terminal 1b is a terminal for inputting a signal DS₂ of a microwave band or a millimeter wave band, for example.

The signal DS₁ and the signal DS₂ are the same in frequency as each other, and the phase of the signal DS₁ is 180 degrees different from the phase of the signal DS₂.

Therefore, the signal DS₁ and the signal DS₂ constitute a differential signal. For convenience of explanation, it is assumed here that the phase of the signal DS₁ is 0 degrees and that the phase of the signal DS₂ is 180 degrees.

The first coupled lines 2 include a first line 11, a second line 12, and a third line 13.

Each of the first line 11, the second line 12, and the third line 13 has a length of a quarter wavelength at the center frequency of the signal DS₁ and the signal DS₂.

The first line 11 is a transmission line having one end 11a coupled to the first signal input terminal 1a.

The second line 12 is a transmission line having one end 12a grounded and the other end 12b coupled to a first signal output terminal 4a, and is electromagnetically coupled to the first line 11.

The third line 13 is a transmission line that is open at one end 13a and electromagnetically coupled to the second line 12.

The second coupled lines 3 include a fourth line 21, a fifth line 22, and a sixth line 23.

Each of the fourth line 21, the fifth line 22, and the sixth line 23 has a length of a quarter wavelength at the center frequency of the signal DS₁ and the signal DS₂.

The fourth line 21 is a transmission line having one end 21a coupled to the other end 11b of the first line 11 and the other end 21b open.

The fifth line 22 is a transmission line in which one end 22a is coupled to a second signal output terminal 4b and the other end 22b is grounded, and is electromagnetically coupled to the fourth line 21.

The sixth line 23 is a transmission line having one end 23a coupled to the other end 13b of the third line 13 and the other end 23b coupled to the second signal input terminal 1b, and is electromagnetically coupled to the fifth line 22.

The first signal output terminal 4a outputs a signal DS₃ output from the first coupled lines 2.

The second signal output terminal 4b outputs a signal DS₄ output from the second coupled lines 3.

Next, the operation will be described.

In the in-phase suppression circuit in FIG. 1, the first line 11 and the second line 12 included in the first coupled lines 2, and the fourth line 21 and the fifth line 22 included in the second coupled lines 3 form a first Marchand balun. In the first embodiment, the passing phase of the first Marchand balun is θ.

Meanwhile, in the in-phase suppression circuit in FIG. 1, the second line 12 and the third line 13 included in the first coupled lines 2, and the fifth line 22 and the sixth line 23 included in the second coupled lines 3 form a second Marchand balun. In the first embodiment, the passing phase of the second Marchand balun is θ.

The second line 12 coupled to the first signal output terminal 4a is shared by the first Marchand balun and the second Marchand balun.

The fifth line 22 coupled to the second signal output terminal 4b is shared by the first Marchand balun and the second Marchand balun.

Since the first line 11, the second line 12, the fourth line 21, and the fifth line 22 form the first Marchand balun, when the signal DS₁ is input from the first signal input terminal 1a, a signal DS₁₋₁ having a phase of (0 + θ) degrees appears at the other end 12b of the second line 12.

Furthermore, a signal DS₁₋₂ having a phase of (180 + θ) degrees appears at one end 22a of the fifth line 22.

Since the second line 12, the third line 13, the fifth line 22, and the sixth line 23 form the second Marchand balun, when the signal DS₂ is input from the second signal input terminal 1b, a signal DS₂₋₁ having a phase of (180 + θ) degree appears at one end 22a of the fifth line 22.

Furthermore, a signal DS₂₋₂ having a phase of (0 + θ) degrees appears at the other end 12b of the second line 12.

Here, the signal DS₁₋₁ and the signal DS₂₋₂ appearing at the other end 12b of the second line 12 are in-phase combined since they both have the phase of (0 + θ) degrees.

As a result, the signal DS₃ having the phase of (0 + θ) degrees is output from the first signal output terminal 4a as a composite signal of the signals DS₁₋₁ and DS₂₋₂.

Moreover, the signal DS₁₋₂ and the signal DS₂₋₁ appearing at the one end 22a of the fifth line 22 are also in-phase combined since they both have the phase of (180 + θ) degrees.

As a result, the signal DS₄ having the phase of (180 + θ) degrees is output from the second signal output terminal 4b as a composite signal of the signals DS₁₋₂ and DS₂₋₁.

Since the phase difference between the signal DS₃ output from the first signal output terminal 4a and the signal DS₄ output from the second signal output terminal 4b is 180 degrees, the signal DS₃ and the signal DS₄ are differential signals.

Next, the operation when an in-phase signal C such as noise is input from the first signal input terminal 1a and the second signal input terminal 1b will be described.

Here, for convenience of explanation, it is assumed that the phase of the in-phase signal C is α.

Since the first line 11, the second line 12, the fourth line 21, and the fifth line 22 form the first Marchand balun, when the in-phase signal C is input from the first signal input terminal 1a, a signal C₁₋₁ having a phase of (α + θ) degrees appears at the other end 12b of the second line 12.

A signal C₁₋₂ having a phase of (180 + α + θ) degrees also appears at the one end 22a of the fifth line 22.

Since the second line 12, the third line 13, the fifth line 22, and the sixth line 23 form the second Marchand balun, when the in-phase signal C is input from the second signal input terminal 1b, a signal C₂₋₁ having a phase of (α + θ) degree appears at the one end 22a of the fifth line 22.

A signal C₂₋₂ having a phase of (180 + α + θ) also appears at the other end 12b of the second line 12.

Here, the signal C₁₋₁ and the signal C₂₋₂ appearing at the other end 12b of the second line 12 are canceled out since they have a phase difference of 180 degrees (= |(α + 8) - (180 + α + θ)|) and they are the same in amplitude as each other.

Likewise, the signal C₁₋₂ and the signal C₂₋₁ appearing at the one end 22a of the fifth line 22 are also canceled out since they have a phase difference of 180 degrees (= |(180 + α + θ) - (α + θ)|) and they are the same in amplitude as each other.

As a result, no in-phase component is output from the first signal output terminal 4a or the second signal output terminal 4b.

Next, characteristics when differential signals and in-phase signals are input to the in-phase suppression circuit of FIG. 1 will be described.

Here, in a case where differential signals are input to the first signal output terminal 4a and the second signal output terminal 4b, balanced signal terminals of an ideal balun capable of generating differential signals are coupled to the first signal output terminal 4a and the second signal output terminal 4b.

Meanwhile, assuming an unbalanced signal terminal of the ideal balun as a port (1) of a characteristic calculation circuit, an unbalanced signal is input to the port (1).

In addition, assuming the first signal output terminal 4a as a port (2) of the characteristic calculation circuit and the second signal output terminal 4b as a port (3) of the characteristic calculation circuit, an S parameter S21 between the port (1) and the port (2) as well as an S parameter S31 between the port (1) and the port (3) are calculated.

Next, in a case where in-phase signals are input to the first signal output terminal 4a and the second signal output terminal 4b, the first signal output terminal 4a and the second signal output terminal 4b are coupled, and an unbalanced signal is input to a port (4) of the characteristic calculation circuit.

In addition, assuming the first signal output terminal 4a as a port (5) of the characteristic calculation circuit and the second signal output terminal 4b as a port (6) of the characteristic calculation circuit, an S parameter S54 between the port (4) and the port (5) as well as an S parameter S64 between the port (4) and the port (6) are calculated.

FIG. 2 is an explanatory graph illustrating the amplitude of the S parameter S21 and the amplitude of the S parameter S31 when differential signals are input.

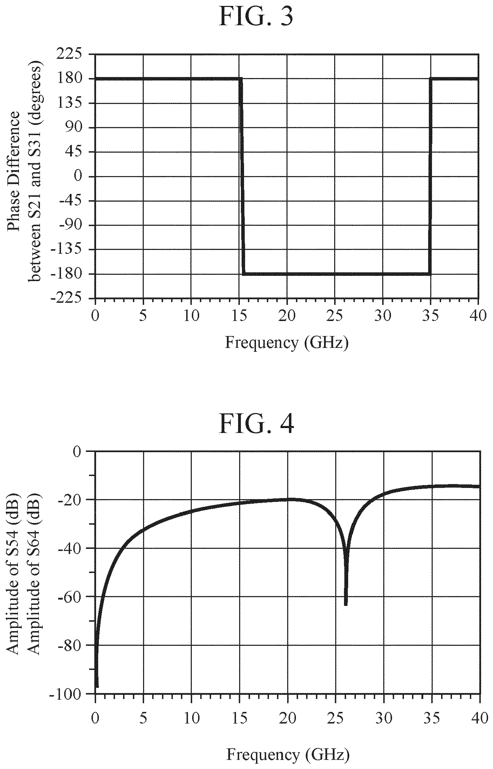

FIG. 3 is an explanatory graph illustrating a phase difference between the S parameter S21 and the S parameter S31 when differential signals are input.

In FIGS. 2 and 3, the lengths of the first line 11, the second line 12, the third line 13, the fourth line 21, the fifth line 22, and the sixth line 23 are each set to a quarter wavelength at 20 GHz.

For this reason, as illustrated in FIG. 2 it can be seen that a passage loss in the in-phase suppression circuit is about -3 dB around a frequency of 20 GHz and that the differential signal is transmitted with almost no loss.

Also as illustrated in FIG. 3, it can be seen that a phase difference between the S parameter S21 and the S parameter S31 is 180 degrees at the frequency of 20 GHz and that transmission as differential signals is carried out.

FIG. 4 is an explanatory graph illustrating the amplitude of the S parameter S54 and the amplitude of the S parameter S64 when in-phase signals are input.

As can be seen from FIG. 4, in-phase signals are attenuated by about 20 dB at the frequency of 20 GHz.

As apparent from the above, according to the first embodiment, included are: the first line 11 having one end 11a coupled to the first signal input terminal 1a; the second line 12 having one end 12a grounded and the other end 12b coupled to the first signal output terminal 4a, the second line 12 electromagnetically coupled to the first line 11; the third line 13 having one end 13a open, the third line 13 electromagnetically coupled to the second line 12; the fourth line 21 having one end 21a coupled to the other end 11b of the first line 11 and the other end 21b open; a fifth line 22 having one end 22a coupled to the second signal output terminal 4b and the other end 22b grounded, the fifth line 22 electromagnetically coupled to the fourth line 21; and the sixth line 23 having one end 23a coupled to the other end 13b of the third line 13 and the other end 23b coupled to the second signal input terminal 1b, the sixth line 23 electromagnetically coupled to the fifth line 22.

Moreover, the first line 11, the second line 12, the third line 13, the fourth line 21, the fifth line 22, and the sixth line 23 have a length of a quarter wavelength at a frequency of signals input from the first signal input terminal 1a and the second signal input terminal 1b.

This exerts the effect of reducing the number of transmission lines as compared with a case of using two Marchand baluns that are independent of each other.

For example, the in-phase suppression circuit disclosed in Non-Patent Literature 1 includes eight transmission lines, whereas in the first embodiment, the number of transmission lines included in the in-phase suppression circuit is six. The number of transmission lines has decreased by two.

Therefore, in the first embodiment, it is possible to miniaturize the in-phase suppression circuit disclosed in Non-Patent Literature 1.

In the first embodiment, it is assumed that the first line 11, the second line 12, the third line 13, the fourth line 21, the fifth line 22, the sixth line 23 are arranged on a plane of a dielectric substrate including an integrated circuit (IC).

However, the first line 11, the second line 12, the third line 13, the fourth line 21, the fifth line 22, and the sixth line 23 is not limited to the arrangement on the plane of a dielectric substrate.

For example, in a multilayer dielectric substrate including an IC, the first line 11, the second line 12, the third line 13, the fourth line 21, the fifth line 22, and the sixth line 23 may be distributed to a plurality of layers, and lines arranged in different layers may be electromagnetically coupled to.

### Second Embodiment

In the in-phase suppression circuit disclosed in Non-Patent Literature 1, the first Marchand balun includes the first to fourth transmission lines, and the second Marchand balun includes the fifth to eighth transmission lines.

There are cases where the manufacture becomes difficult if the distance between the lines is extremely narrow when the first to eighth transmission lines are formed on a dielectric substrate.

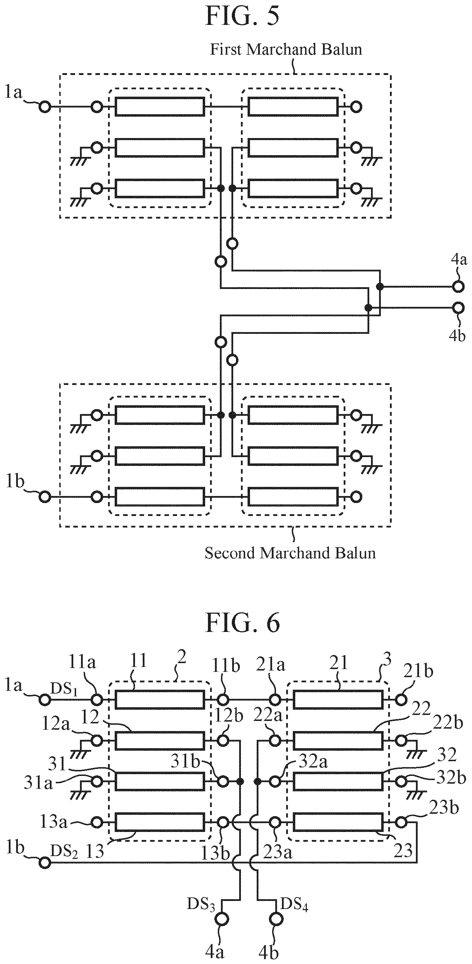

As illustrated in FIG. 5, adding one transmission line to each of the coupled lines in the first and second Marchand baluns makes it possible to configure the first and second Marchand baluns even in a case where the amount of coupling between adjacent lines is reduced.

If the first and second Marchand baluns can be configured even in a case where the amount of coupling between adjacent lines is reduced, the distance between the lines can be increased, thereby facilitating manufacturing.

FIG. 5 is a configuration diagram illustrating a conventional in-phase suppression circuit including a first Marchand balun including first to sixth transmission lines and a second Marchand balun including seventh to twelfth transmission lines.

The first to twelfth transmission lines have a length of a quarter wavelength at the frequency of input differential signals.

FIG. 6 is a configuration diagram illustrating an in-phase suppression circuit according to a second embodiment of the present invention. In FIG. 6, the same symbol as that in FIG. 1 represents the same or a corresponding part and thus descriptions thereof are omitted.

A seventh line 31 is a transmission line having one end 31a grounded and the other end 31b coupled to the first signal output terminal 4a. The seventh line 31 is arranged between the second line 12 and the third line 13 and is electromagnetically coupled to each of the second line 12 and the third line 13.

An eighth line 32 is a transmission line having one end 32a coupled to the second signal output terminal 4b and the other end 32b grounded. The eighth line 32 is arranged between the fifth line 22 and the sixth line 23 and is electromagnetically coupled to each of the fifth line 22 and the sixth line 23.

Each of the seventh line 31 and the eighth line 32 has a length of a quarter wavelength at the center frequency of the signal DS₁ and the signal DS₂.

Next, the operation will be described.

In the in-phase suppression circuit in FIG. 6, the first line 11, the second line 12, and the seventh line 31 included in the first coupled lines 2, and the fourth line 21, the fifth line 22, and the eighth line 32 included in the second coupled lines 3 form a first Marchand balun.

Meanwhile, in the in-phase suppression circuit in FIG. 6, the second line 12, the seventh line 31, and the third line 13 included in the first coupled lines 2, and the fifth line 22, the eighth line 32, and the sixth line 23 included in the second coupled lines 3 form a second Marchand balun.

The second line 12 and the seventh line 31 coupled to the first signal output terminal 4a are shared by the first Marchand balun and the second Marchand balun.

The fifth line 22 and the eighth line 32 coupled to the second signal output terminal 4b are shared by the first Marchand balun and the second Marchand balun.

Since the first line 11, the second line 12, the seventh line 31, the fourth line 21, the fifth line 22, and the eighth line 32 form the first Marchand balun, when the signal DS₁ is input from the first signal input terminal 1a, a signal DS₁₋₁ having a phase of (0 + θ) degrees appears at the other end 12b of the second line 12 and the other end 31b of the seventh line 31.

Furthermore, a signal DS₁₋₂ having a phase of (180 + θ) degrees appears at the one end 22a of the fifth line 22 and the one end 32a of the eighth line 32.

Since the second line 12, the seventh line 31, the third line 13, the fifth line 22, the eighth line 32, and the sixth line 23 form the second Marchand balun, when the signal DS₂ is input from the second signal input terminal 1b, a signal DS₂₋₁ having a phase of (180 + θ) degrees appears at the one end 22a of the fifth line 22 and the one end 32a of the eighth line 32.

Furthermore, a signal DS₂₋₂ having a phase of (0 + θ) degrees appears at the other end 12b of the second line 12 and the other end 31b of the seventh line 31.

Here, the signal DS₁₋₁ and the signal DS₂₋₂ appearing at the other end 12b of the second line 12 and the other end 31b of the seventh line 31 are in-phase combined since they both have the phase of (0 + θ) degrees.

As a result, the signal DS₃ having the phase of (0 + θ) degrees is output from the first signal output terminal 4a as a composite signal of the signals DS₁₋₁ and DS₂₋₂.

Moreover, the signal DS₁₋₂ and the signal DS₂₋₁ appearing at the one end 22a of the fifth line 22 and the one end 32a of the eighth line 32 are also in-phase combined since they both have the phase of (180 + θ) degrees.

As a result, the signal DS₄ having the phase of (180 + θ) degrees is output from the second signal output terminal 4b as a composite signal of the signals DS₁₋₂ and DS₂₋₁.

Since the phase difference between the signal DS₃ output from the first signal output terminal 4a and the signal DS₄ output from the second signal output terminal 4b is 180 degrees, the signal DS₃ and the signal DS₄ are differential signals.

Next, the operation when an in-phase signal C such as noise is input from the first signal input terminal 1a and the second signal input terminal 1b will be described.

Since the first line 11, the second line 12, the seventh line 31, the fourth line 21, the fifth line 22, and the eighth line 32 form the first Marchand balun, when an in-phase signal C is input from the first signal input terminal 1a, a signal C₁₋₁ having a phase of (α + θ) degrees appears at the other end 12b of the second line 12 and the other end 31b of the seventh line 31.

In addition, a signal C₁₋₂ having a phase of (180 + α + θ) degrees appears at the one end 22a of the fifth line 22 and the one end 32a of the eighth line 32.

Since the second line 12, the seventh line 31, the third line 13, the fifth line 22, the eighth line 32, and the sixth line 23 form the second Marchand balun, when the in-phase signal C is input from the second signal input terminal 1b, a signal C₂₋₁ having a phase of (α + θ) degrees appears at the one end 22a of the fifth line 22 and the one end 32a of the eighth line 32.

Furthermore, a signal C₂₋₂ having a phase of (180 + α + θ) appears at the other end 12b of the second line 12 and the other end 31b of the seventh line 31.

Here, the signal C₁₋₁ and the signal C₂₋₂ appearing at the other end 12b of the second line 12 and the other end 31b of the seventh line 31 are canceled out since they have a phase difference of 180 degrees (= |(α + θ) - (180 + α + θ)|) and they are the same in amplitude as each other.

Likewise, the signal C₁₋₂ and the signal C₂₋₁ appearing at the one end 22a of the fifth line 22 and the one end 32a of the eighth line 32 are also canceled out since they have a phase difference of 180 degrees (= |(180 + α + θ) - (α + θ)|) and they are the same in amplitude as each other.

As a result, no in-phase component is output from the first signal output terminal 4a or the second signal output terminal 4b.

In the in-phase suppression circuit in FIG. 6, the seventh line 31 is added to the first coupled lines 2, and the eighth line 32 is added to the second coupled lines 3, and thus it is possible to configure the first and second Marchand baluns even in a case where the amount of coupling between adjacent lines is reduced like in the conventional in-phase suppression circuit illustrated in FIG. 5.

If the first and second Marchand baluns can be configured even in a case where the amount of coupling between adjacent lines is reduced, the distance between the lines can be increased, thereby facilitating manufacturing.

As is apparent from the above, according to the second embodiment, further included are: the seventh line 31 having one end 31a grounded and the other end 31b coupled to the first signal output terminal 4a, the seventh line 31 arranged between the second line 12 and the third line 13 and electromagnetically coupled to each of the second line 12 and the third line 13; and the eighth line 32 having one end 32a coupled to the second signal output terminal 4b and the other end 32b grounded, the eighth line 32 arranged between the fifth line 22 and the sixth line 23 and electromagnetically coupled to each of the fifth line 22 and the sixth line 23, and each of the seventh line 31 and the eighth line 32 has a length of a quarter wavelength at the center frequency of the signal DS₁ and the signal DS₂.

This exerts the effect of reducing the number of transmission lines as compared with a case of using two Marchand baluns that are independent of each other.

For example, the conventional in-phase suppression circuit illustrated in FIG. 5 includes twelve transmission lines, whereas in the second embodiment, the number of transmission lines included in the in-phase suppression circuit is eight. The number of transmission lines has decreased by four.

Therefore, in the second embodiment it is further possible to miniaturize the conventional in-phase suppression circuit illustrated in FIG. 5.

### Third Embodiment

In the in-phase suppression circuit disclosed in Non-Patent Literature 1, the first Marchand balun includes the first to fourth transmission lines, and the second Marchand balun includes the fifth to eighth transmission lines.

There are cases where the manufacture becomes difficult if the distance between the lines is extremely narrow when the first to eighth transmission lines are formed on a dielectric substrate.

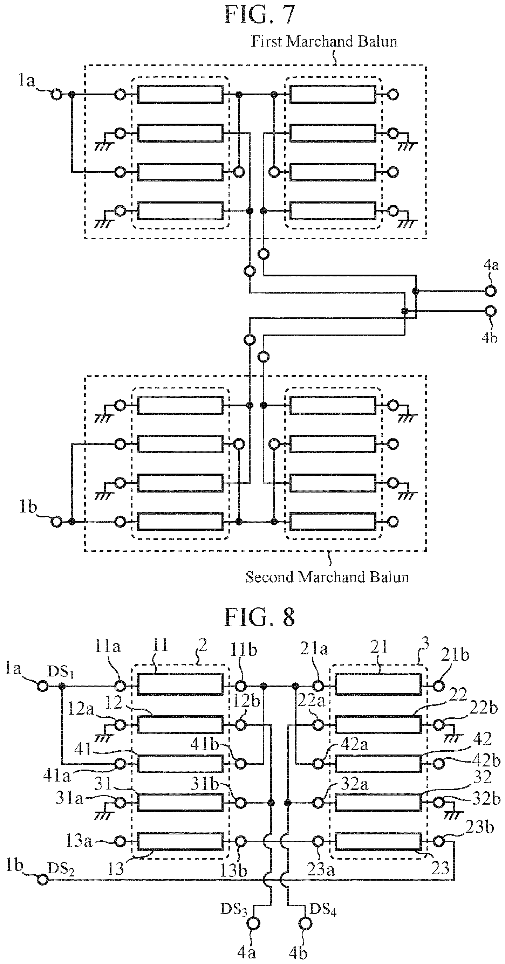

As illustrated in FIG. 7, adding two transmission lines to each of the coupled lines in the first and second Marchand baluns makes it possible to configure the first and second Marchand baluns even in a case where the amount of coupling between adjacent lines is reduced.

If the first and second Marchand baluns can be configured even in a case where the amount of coupling between adjacent lines is reduced, the distance between the lines can be increased, thereby facilitating manufacturing.

FIG. 7 is a configuration diagram illustrating a conventional in-phase suppression circuit including a first Marchand balun including first to eighth transmission lines and a second Marchand balun including ninth to sixteenth transmission lines.

The first to sixteenth transmission lines have a length of a quarter wavelength at the frequency of input differential signals.

FIG. 8 is a configuration diagram illustrating an in-phase suppression circuit according to the third embodiment of the present invention. In FIG. 8, the same symbol as that in FIGS. 1 and 6 represents the same or a corresponding part and thus descriptions thereof are omitted.

A ninth line 41 is a transmission line having one end 41a coupled to the first signal input terminal 1a and the other end 41b coupled to the other end 11b of the first line 11. The ninth line 41 is arranged between the second line 12 and the seventh line 31 and electromagnetically coupled to each of the second line 12 and the seventh line 31.

A tenth line 42 is a transmission line having one end 42a coupled to one end 21a of the fourth line 21 and the other end 42b open. The tenth line 42 is arranged between the fifth line 22 and the eighth line 32 and electromagnetically coupled to each of the fifth line 22 and the eighth line 32.

Each of the ninth line 41 and the tenth line 42 has a length of a quarter wavelength at the center frequency of a signal DS₁ and a signal DS₂.

Next, the operation will be described.

In the in-phase suppression circuit in FIG. 8, the first line 11, the second line 12, the ninth line 41, and the seventh line 31 included in the first coupled lines 2, and the fourth line 21, the fifth line 22, the tenth line 42, and the eighth line 32 included in the second coupled lines 3 form a first Marchand balun.

In the in-phase suppression circuit in FIG. 8, the second line 12, the ninth line 41, the seventh line 31, and the third line 13 included in the first coupled lines 2, and the fifth line 22, the tenth line 42, the eighth line 32, and the sixth line 23 included in the second coupled lines 3 form a second Marchand balun.

The second line 12, the ninth line 41, and the seventh line 31 coupled to the first signal output terminal 4a are shared by the first Marchand balun and the second Marchand balun.

The fifth line 22, the tenth line 42, and the eighth line 32 coupled to the second signal output terminal 4b are shared by the first Marchand balun and the second Marchand balun.

Since the first line 11, the second line 12, the ninth line 41, the seventh line 31, the fourth line 21, the fifth line 22, the tenth line 42, and the eighth line 32 form the first Marchand balun, when the signal DS₁ is input from the first signal input terminal 1a, a signal DS₁₋₁ having a phase of (0 + θ) degrees appears at the other end 12b of the second line 12 and the other end 31b of the seventh line 31.

Furthermore, a signal DS₁₋₂ having a phase of (180 + θ) degrees appears at the one end 22a of the fifth line 22 and the one end 32a of the eighth line 32.

Since the second line 12, the ninth line 41, the seventh line 31, the third line 13, the fifth line 22, the tenth line 42, the eighth line 32, and the sixth line 23 form the second Marchand balun, when the signal DS₂ is input from the second signal input terminal 1b, a signal DS₂₋₁ having a phase of (180 + θ) degrees appears at the one end 22a of the fifth line 22 and the one end 32a of the eighth line 32.

Furthermore, a signal DS₂₋₂ having a phase of (0 + θ) degrees appears at the other end 12b of the second line 12 and the other end 31b of the seventh line 31.

Here, the signal DS₁₋₁ and the signal DS₂₋₂ appearing at the other end 12b of the second line 12 and the other end 31b of the seventh line 31 are in-phase combined since they both have the phase of (0 + θ) degrees.

As a result, the signal DS₃ having the phase of (0 + θ) degrees is output from the first signal output terminal 4a as a composite signal of the signals DS₁₋₁ and DS₂₋₂.

Moreover, the signal DS₁₋₂ and the signal DS₂₋₁ appearing at the one end 22a of the fifth line 22 and the one end 32a of the eighth line 32 are also in-phase combined since they both have the phase of (180 + θ) degrees.

As a result, the signal DS₄ having the phase of (180 + θ) degrees is output from the second signal output terminal 4b as a composite signal of the signals DS₁₋₂ and DS₂₋₁.

Since the phase difference between the signal DS₃ output from the first signal output terminal 4a and the signal DS₄ output from the second signal output terminal 4b is 180 degrees, the signal DS₃ and the signal DS₄ are differential signals.

Next, the operation when an in-phase signal C such as noise is input from the first signal input terminal 1a and the second signal input terminal 1b will be described.

Since the first line 11, the second line 12, the ninth line 41, the seventh line 31, the fourth line 21, the fifth line 22, the tenth line 42, and the eighth line 32 form the first Marchand balun, when an in-phase signal C is input from the first signal input terminal 1a, a signal C₁₋₁ having a phase of (α + θ) degrees appears at the other end 12b of the second line 12 and the other end 31b of the seventh line 31.

In addition, a signal C₁₋₂ having a phase of (180 + α + θ) degrees appears at the one end 22a of the fifth line 22 and the one end 32a of the eighth line 32.

Since the second line 12, the ninth line 41, the seventh line 31, the third line 13, the fifth line 22, the tenth line 42, the eighth line 32, and the sixth line 23 form the second Marchand balun, when the in-phase signal C is input from the second signal input terminal 1b, a signal C₂₋₁ having a phase of (α + θ) degrees appears at the one end 22a of the fifth line 22 and the one end 32a of the eighth line 32.

Furthermore, a signal C₂₋₂ having a phase of (180 + α + θ) appears at the other end 12b of the second line 12 and the other end 31b of the seventh line 31.

Here, the signal C₁₋₁ and the signal C₂₋₂ appearing at the other end 12b of the second line 12 and the other end 31b of the seventh line 31 are canceled out since they have a phase difference of 180 degrees (= |(α + θ) - (180 + α + θ)|) and they are the same in amplitude as each other.

Likewise, the signal C₁₋₂ and the signal C₂₋₁ appearing at the one end 22a of the fifth line 22 and the one end 32a of the eighth line 32 are also canceled out since they have a phase difference of 180 degrees (= |(180 + α + θ) - (α + θ)|) and they are the same in amplitude as each other.

As a result, no in-phase component is output from the first signal output terminal 4a or the second signal output terminal 4b.

In the in-phase suppression circuit in FIG. 8, the seventh line 31 and the ninth line 41 are added to the first coupled lines 2, and the eighth line 32 and the tenth line 42 are added to the second coupled lines 3, and thus it is possible to configure the first and second Marchand baluns even in a case where the amount of coupling between adjacent lines is reduced like in the conventional in-phase suppression circuit illustrated in FIG. 7.

If the first and second Marchand baluns can be configured even in a case where the amount of coupling between adjacent lines is reduced, the distance between the lines can be increased, thereby facilitating manufacturing.

As is apparent from the above, according to the third embodiment, further included are: the ninth line 41 having the one end 41a coupled to the first signal input terminal 1a and the other end 41b coupled to the other end 11b of the first line 11, the ninth line 41 arranged between the second line 12 and the seventh line 31 and electromagnetically coupled to each of the second line 12 and the seventh line 31; and the tenth line 42 having the one end 42a coupled to the one end 21a of the fourth line 21 and the other end 42b open, the tenth line 42 arranged between the fifth line 22 and the eighth line 32 and electromagnetically coupled to each of the fifth line 22 and the eighth line 32, and each of the ninth line 41 and the tenth line 42 have a length of a quarter wavelength at the center frequency of the signal DS₁ and the signal DS₂.

This exerts the effect of reducing the number of transmission lines as compared with a case of using two Marchand baluns that are independent of each other.

For example, the conventional in-phase suppression circuit illustrated in FIG. 7 includes sixteen transmission lines, whereas in the third embodiment, the number of transmission lines included in the in-phase suppression circuit is ten. The number of transmission lines has decreased by six.

Therefore, in the third embodiment, it is further possible to miniaturize the conventional in-phase suppression circuit illustrated in FIG. 7.

### Fourth Embodiment

In the first embodiment, the example has been described in which the other end 21b of the fourth line 21 is open, the one end 12a of the second line 12 is grounded, the other end 22b of the fifth line 22 is grounded, and the one end 13a of the third line 13 is open.

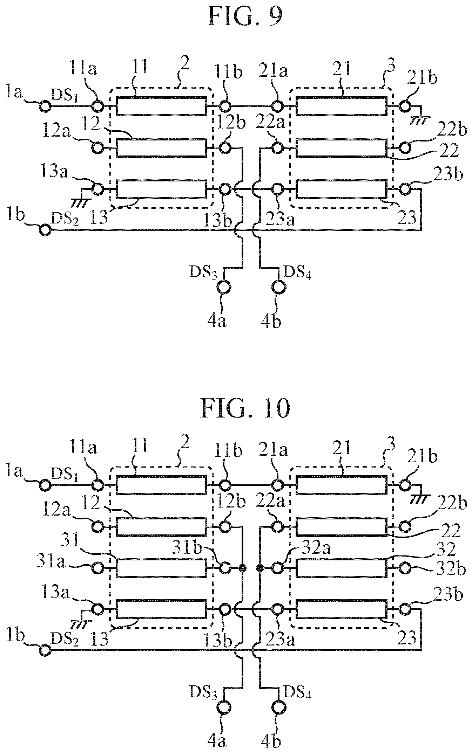

In a fourth embodiment, as illustrated in FIG. 9, an example will be described in which the other end 21b of the fourth line 21 is grounded, the one end 12a of the second line 12 is open, the other end 22b of the fifth line 22 is open, and the one end 13a of the third line 13 is grounded.

FIG. 9 is a configuration diagram illustrating an in-phase suppression circuit according to the fourth embodiment of the present invention.

In the in-phase suppression circuit in FIG. 9, the first line 11 and the second line 12 included in the first coupled lines 2, and the fourth line 21 and the fifth line 22 included in the second coupled lines 3 form a first Marchand balun like in the first embodiment.

In addition, in the in-phase suppression circuit in FIG. 9, the second line 12 and the third line 13 included in the first coupled lines 2, and the fifth line 22 and the sixth line 23 included in the second coupled lines 3 form a second Marchand balun like in the first embodiment.

Like in the first embodiment, the second line 12 coupled to the first signal output terminal 4a is shared by the first Marchand balun and the second Marchand balun.

The fifth line 22 coupled to the second signal output terminal 4b is shared by the first Marchand balun and the second Marchand balun like in the first embodiment.

The present embodiment is similar to the first embodiment in that the first line 11, the second line 12, the fourth line 21, and the fifth line 22 form the first Marchand balun.

The first Marchand balun in the fourth embodiment is different from the first Marchand balun in the first embodiment in the state of some ends of the lines.

Specifically, in the first embodiment, the other end 21b of the fourth line 21 is open, the one end 12a of the second line 12 is grounded, the other end 22b of the fifth line 22 is grounded, and the one end 13a of the third line 13 is open.

In the fourth embodiment, the other end 21b of the fourth line 21 is grounded, the one end 12a of the second line 12 is open, the other end 22b of the fifth line 22 is open, and the one end 13a of the third line 13 is grounded.

However, the operation itself is similar for the first Marchand balun in the fourth embodiment and the first Marchand balun in the first embodiment.

Therefore, like in the first embodiment, differential signals are output from the first signal output terminal 4a and the second signal output terminal 4b, and no in-phase component is output from the first signal output terminal 4a or the second signal output terminal 4b.

As apparent from the above, according to the fourth embodiment, included are: the first line 11 having one end 11a coupled to the first signal input terminal 1a; the second line 12 having one end 12a open and the other end 12b coupled to the first signal output terminal 4a, the second line 12 electromagnetically coupled to the first line 11; the third line 13 having one end 13a grounded, the third line 13 electromagnetically coupled to the second line 12; the fourth line 21 having one end 21a coupled to the other end 11b of the first line 11 and the other end 21b grounded; the fifth line 22 having one end 22a coupled to the second signal output terminal 4b and the other end 22b open, the fifth line 22 electromagnetically coupled to the fourth line 21; and the sixth line 23 having one end 23a coupled to the other end 13b of the third line 13 and the other end 23b coupled to the second signal input terminal 1b, the sixth line 23 electromagnetically coupled to the fifth line 22.

Moreover, the first line 11, the second line 12, the third line 13, the fourth line 21, the fifth line 22, and the sixth line 23 have a length of a quarter wavelength at a frequency of signals input from the first signal input terminal 1a and the second signal input terminal 1b.

This exerts the effect of reducing the number of transmission lines as compared with a case of using two Marchand baluns that are independent of each other.

For example, the in-phase suppression circuit disclosed in Non-Patent Literature 1 includes eight transmission lines, whereas in the fourth embodiment, the number of transmission lines included in the in-phase suppression circuit is six. The number of transmission lines has decreased by two.

Therefore, in the fourth embodiment, it is possible to miniaturize the in-phase suppression circuit disclosed in Non-Patent Literature 1.

### Fifth Embodiment

In the second embodiment, the example has been described in which the other end 21b of the fourth line 21 is open, the one end 12a of the second line 12 is grounded, the other end 22b of the fifth line 22 is grounded, and the one end 13a of the third line 13 is open.

In the second embodiment, an example is described in which the one end 31a of the seventh line 31 is grounded and the other end 32b of the eighth line 32 is grounded.

In the fifth embodiment, as illustrated in FIG. 10, the other end 21b of the fourth line 21 is grounded, the one end 12a of the second line 12 is open, the other end 22b of the fifth line 22 is open, and the one end 13a of the third line 13 is grounded.

An example in which the one end 31a of the seventh line 31 is open and the other end 32b of the eighth line 32 is open will be described.

FIG. 10 is a configuration diagram illustrating an in-phase suppression circuit according to the fifth embodiment of the present invention.

Like in the second embodiment, in the in-phase suppression circuit in FIG. 10, the first line 11, the second line 12, and the seventh line 31 included in the first coupled lines 2 and the fourth line 21, the fifth line 22, and the eighth line 32 included in the second coupled lines 3 form a first Marchand balun.

Meanwhile, in the in-phase suppression circuit in FIG. 10, the second line 12, the seventh line 31, and the third line 13 included in the first coupled lines 2, and the fifth line 22, the eighth line 32, and the sixth line 23 included in the second coupled lines 3 form a second Marchand balun.

The second line 12 and the seventh line 31 coupled to the first signal output terminal 4a are shared by the first Marchand balun and the second Marchand balun.

The fifth line 22 and the eighth line 32 coupled to the second signal output terminal 4b are shared by the first Marchand balun and the second Marchand balun.

The present embodiment is similar to the second embodiment in that the first line 11, the second line 12, the seventh line 31, the fourth line 21, the fifth line 22, and the eighth line 32 form the first Marchand balun.

The first Marchand balun in the fifth embodiment is different from the first Marchand balun in the second embodiment in the state of some ends of the lines.

Specifically, in the second embodiment, the other end 21b of the fourth line 21 is open, the one end 12a of the second line 12 is grounded, the other end 22b of the fifth line 22 is grounded, and the one end 13a of the third line 13 is open. Moreover, the one end 31a of the seventh line 31 is grounded, and the other end 32b of the eighth line 32 is grounded.

In the fifth embodiment, the other end 21b of the fourth line 21 is grounded, the one end 12a of the second line 12 is open, the other end 22b of the fifth line 22 is open, and the one end 13a of the third line 13 is grounded. The one end 31a of the seventh line 31 is open, and the other end 32b of the eighth line 32 is open.

However, the operation itself is similar for the first Marchand balun in the fifth embodiment and the first Marchand balun in the second embodiment.

Therefore, like in the second embodiment, differential signals are output from the first signal output terminal 4a and the second signal output terminal 4b, and no in-phase component is output from the first signal output terminal 4a or the second signal output terminal 4b.

As is apparent from the above, according to the fifth embodiment, further included are: the seventh line 31 having the one end 31a open and the other end 31b coupled to the first signal output terminal 4a, the seventh line 31 arranged between the second line 12 and the third line 13 and electromagnetically coupled to each of the second line 12 and the third line 13; and the eighth line 32 having the one end 32a coupled to the second signal output terminal 4b and the other end 32b open, the eighth line 32 arranged between the fifth line 22 and the sixth line 23 and electromagnetically coupled to each of the fifth line 22 and the sixth line 23, and each of the seventh line 31 and the eighth line 32 has a length of a quarter wavelength at the center frequency of the signal DS₁ and the signal DS₂.

This exerts the effect of reducing the number of transmission lines as compared with a case of using two Marchand baluns that are independent of each other.

For example, the conventional in-phase suppression circuit illustrated in FIG. 5 includes twelve transmission lines, whereas in the fifth embodiment, the number of transmission lines included in the in-phase suppression circuit is eight. The number of transmission lines has decreased by four.

Therefore, in the fifth embodiment, it is further possible to miniaturize the conventional in-phase suppression circuit illustrated in FIG. 5.

### Sixth Embodiment

In the third embodiment, the example has been described in which the other end 21b of the fourth line 21 is open, the one end 12a of the second line 12 is grounded, the other end 22b of the fifth line 22 is grounded, and the one end 13a of the third line 13 is open.

In the third embodiment, the example has been described in which the one end 31a of the seventh line 31 is grounded, the other end 32b of the eighth line 32 is grounded, and the other end 42b of the tenth line 42 is open.

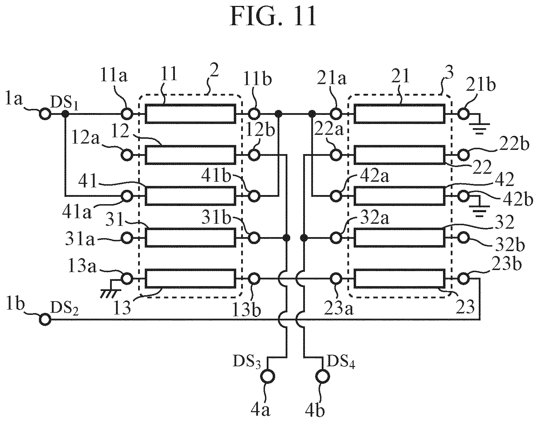

In this sixth embodiment, as illustrated in FIG. 11, the other end 21b of the fourth line 21 is grounded, the one end 12a of the second line 12 is open, the other end 22b of the fifth line 22 is open, and the one end 13a of the third line 13 is grounded.

An example will be described in which the one end 31a of the seventh line 31 is open, the other end 32b of the eighth line 32 is open, and the other end 42b of the tenth line 42 is grounded.

FIG. 11 is a configuration diagram illustrating an in-phase suppression circuit according to the sixth embodiment of the present invention.

Like in the third embodiment, in the in-phase suppression circuit in FIG. 11, the first line 11, the second line 12, the ninth line 41, and the seventh line 31 included in the first coupled lines 2 and the fourth line 21, the fifth line 22, the tenth line 42, and the eighth line 32 included in the second coupled lines 3 form a first Marchand balun.

In the in-phase suppression circuit in FIG. 11, the second line 12, the ninth line 41, the seventh line 31, and the third line 13 included in the first coupled lines 2, and the fifth line 22, the tenth line 42, the eighth line 32, and the sixth line 23 included in the second coupled lines 3 form a second Marchand balun.

The second line 12, the ninth line 41, and the seventh line 31 coupled to the first signal output terminal 4a are shared by the first Marchand balun and the second Marchand balun.

The fifth line 22, the tenth line 42, and the eighth line 32 coupled to the second signal output terminal 4b are shared by the first Marchand balun and the second Marchand balun.

The present embodiment is similar to the third embodiment in that the first line 11, the second line 12, the ninth line 41, the seventh line 31, the fourth line 21, the fifth line 22, the tenth line 42, and the eighth line 32 form the first Marchand balun.

The first Marchand balun in the sixth embodiment is different from the first Marchand balun in the third embodiment in the state of some ends of the lines.

Specifically, in the third embodiment, the other end 21b of the fourth line 21 is open, the one end 12a of the second line 12 is grounded, the other end 22b of the fifth line 22 is grounded, and the one end 13a of the third line 13 is open. The one end 31a of the seventh line 31 is grounded, the other end 32b of the eighth line 32 is grounded, and the other end 42b of the tenth line 42 is open.

In the sixth embodiment, the other end 21b of the fourth line 21 is grounded, the one end 12a of the second line 12 is open, the other end 22b of the fifth line 22 is open, and the one end 13a of the third line 13 is grounded. The one end 31a of the seventh line 31 is open, the other end 32b of the eighth line 32 is open, and the other end 42b of the tenth line 42 is grounded.

However, the operation itself is similar for the first Marchand balun in the sixth embodiment and the first Marchand balun in the third embodiment.

Therefore, like in the third embodiment, differential signals are output from the first signal output terminal 4a and the second signal output terminal 4b, and no in-phase component is output from the first signal output terminal 4a and the second signal output terminal 4b.

As is apparent from the above, according to the sixth embodiment, further included are: the ninth line 41 having the one end 41a coupled to the first signal input terminal 1a and the other end 41b coupled to the other end 11b of the first line 11, the ninth line 41 arranged between the second line 12 and the seventh line 31 and electromagnetically coupled to each of the second line 12 and the seventh line 31; and the tenth line 42 having the one end 42a coupled to the one end 21a of the fourth line 21 and the other end 42b grounded, the tenth line 42 arranged between the fifth line 22 and the eighth line 32 and electromagnetically coupled to each of the fifth line 22 and the eighth line 32, and each of the ninth line 41 and the tenth line 42 have a length of a quarter wavelength at the center frequency of the signal DS₁ and the signal DS₂.

This exerts the effect of reducing the number of transmission lines as compared with a case of using two Marchand baluns that are independent of each other.

For example, the in-phase suppression circuit illustrated in FIG. 7 includes sixteen transmission lines, whereas in the sixth embodiment, the number of transmission lines included in the in-phase suppression circuit is ten. The number of transmission lines has decreased by six.

Therefore, in the sixth embodiment, it is further possible to miniaturize the conventional in-phase suppression circuit illustrated in FIG. 7.

Note that the present invention may include a flexible combination of the respective embodiments, a modification of any component of the embodiments, or an omission of any component in the embodiments within the scope of the present invention.

### INDUSTRIAL APPLICABILITY

The present invention is suitable for an in-phase suppression circuit including a plurality of lines having a length of a quarter wavelength at a frequency of an input signal.

### REFERENCE SIGNS LIST

1a: first signal input terminal,
1b: second signal input terminal,
2: first coupled lines,
3: second coupled lines,
4a: first signal output terminal,
4b: second signal output terminal,
11: first line,
11a: one end of the first line 11,
11b: the other end of the first line 11,
12: second line,
12a: one end of the second line 12,
12b: the other end of the second line 12,
13: third line,
13a: one end of the third line 13,
13b: the other end of the third line 13,
21: fourth line,
21a: one end of the fourth line 21,
21b: the other end of the fourth line 21,
22: fifth line,
22a: one end of the fifth line 22,
22b: the other end of the fifth line 22,
23: sixth line,
23a: one end of the sixth line 23,
23b: the other end of the sixth line 23,
31: seventh line,
31a: one end of the seventh line 31,
31b: the other end of the seventh line 31,
32: eighth line,
32a: one end of the eighth line 32,
32b: the other end of the eighth line 32,
41: ninth line,
41a: one end of the ninth line 41,
41b: the other end of the ninth line 41,
42: tenth line,
42a: one end of the tenth line 42,
42b: the other end of the tenth line 42

## Claims

1. An in-phase suppression circuit comprising:
a first line in which one end thereof is coupled to a first signal input terminal;
a second line in which one end thereof is grounded and the other end thereof is coupled to a first signal output terminal, the second line being electromagnetically coupled to the first line;
a third line in which one end thereof is open, the third line being electromagnetically coupled to the second line;
a fourth line in which one end thereof is coupled to the other end of the first line and the other end thereof is open;
a fifth line in which one end thereof is coupled to a second signal output terminal and the other end thereof is grounded, the fifth line being electromagnetically coupled to the fourth line; and
a sixth line in which one end thereof is coupled to the other end of the third line and the other end thereof is coupled to a second signal input terminal, the sixth line being electromagnetically coupled to the fifth line,
wherein the first to sixth lines have a length of a quarter wavelength at a frequency of signals input from the first and second signal input terminals.

2. The in-phase suppression circuit according to claim 1, further comprising:
a seventh line in which one end thereof is grounded and the other end thereof is coupled to the first signal output terminal, the seventh line being arranged between the second line and the third line and electromagnetically coupled to each of the second line and the third line; and
an eighth line in which one end thereof is coupled to the second signal output terminal and the other end thereof is grounded, the eighth line being arranged between the fifth line and the sixth line and electromagnetically coupled to each of the fifth line and the sixth line,
wherein the seventh and eighth lines have a length of a quarter wavelength at the frequency of the signals input from the first and second signal input terminals.

3. The in-phase suppression circuit according to claim 2, further comprising:
a ninth line in which one end thereof is coupled to the first signal input terminal and the other end thereof is coupled to the other end of the first line, the ninth line being arranged between the second line and the seventh line and electromagnetically coupled to each of the second line and the seventh line; and
a tenth line in which one end thereof is coupled to the one end of the fourth line and the other end thereof is open, the tenth line being arranged between the fifth line and the eighth line and electromagnetically coupled to each of the fifth line and the eighth line,
wherein the ninth and tenth lines have a length of a quarter wavelength at the frequency of the signals input from the first and second signal input terminals.

4. An in-phase suppression circuit comprising:
a first line in which one end thereof is coupled to a first signal input terminal;
a second line in which one end thereof is open and the other end thereof is coupled to a first signal output terminal, the second line being electromagnetically coupled to the first line;
a third line in which one end thereof is grounded, the third line being electromagnetically coupled to the second line;
a fourth line in which one end thereof is coupled to the other end of the first line and the other end thereof is grounded;
a fifth line in which one end thereof is coupled to a second signal output terminal and the other end thereof is open, the fifth line being electromagnetically coupled to the fourth line; and
a sixth line in which one end thereof is coupled to the other end of the third line and the other end thereof is coupled to a second signal input terminal, the sixth line being electromagnetically coupled to the fifth line,
wherein the first to sixth lines have a length of a quarter wavelength at a frequency of signals input from the first and second signal input terminals.

5. The in-phase suppression circuit according to claim 4, further comprising:
a seventh line in which one end thereof is open and the other end thereof is coupled to the first signal output terminal, the seventh line being arranged between the second line and the third line and electromagnetically coupled to each of the second line and the third line; and
an eighth line in which one end thereof is coupled to the second signal output terminal and the other end thereof open, the eighth line being arranged between the fifth line and the sixth line and electromagnetically coupled to each of the fifth line and the sixth line,
wherein the seventh and eighth lines have a length of a quarter wavelength at the frequency of the signals input from the first and second signal input terminals.

6. The in-phase suppression circuit according to claim 5, further comprising:
a ninth line in which one end thereof is coupled to the first signal input terminal and the other end thereof is coupled to the other end of the first line, the ninth line being arranged between the second line and the seventh line and electromagnetically coupled to each of the second line and the seventh line; and
a tenth line in which one end thereof is coupled to the one end of the fourth line and the other end thereof is grounded, the tenth line being arranged between the fifth line and the eighth line and electromagnetically coupled to each of the fifth line and the eighth line,
wherein the ninth and tenth lines have a length of a quarter wavelength at the frequency of the signals input from the first and second signal input terminals.
